# FASCICULE DE BREVET EUROPEEN

(11) **EP 0 355 917 B1**
(45) Date de publication et mention de la délivrance du brevet: **01.06.1994**
(21) Numéro de dépôt: 89202098.3
(22) Date de dépôt: 17.08.1989
(51) Int. Cl.: G11C 8/00

(54) **Unité de mémoire adressable à circuit de sélection d'unité amélioré**
Adressierbare Speichereinheit mit Einheitsauswahlschaltung
Addressable memory unit with a unit selection circuit

(30) Priorité: 19.08.1988 FR 8811035
(43) Date de publication de la demande: 28.02.1990
(73) Titulaire: Philips Electronics N.V., 5621 BA Eindhoven (NL)
(72) Inventeur: O'Connell, Cormac, NL-5656 AA Eindhoven (NL); Pfennings, Leo, NL-5656 AA Eindhoven (NL); Voss, Peter, NL-5656 AA Eindhoven (NL); Davies, Tom, NL-5656 AA Eindhoven (NL); Ontrop, Hans, NL-5656 AA Eindhoven (NL); Phelan, Cathal, NL-5656 AA Eindhoven (NL)
(74) Mandataire: Caron, Jean

(56) Documents cités:
- US-A- 4 412 309
- US-A- 4 651 304
- IBM TECHNICAL DISCLOSURE BULLETIN, vol. 26, no. 12, mai 1984, pages 6469-6470,New York, US; R.J.HENGST et al.: "Address buffer"
- IEEE JOURNAL OF SOLID-STATE CIRCUITS, vol. SC-18, no. 5, octobre 1983, pages457-463, IEEE, New York, US; R.J.C. CHWANG et al.: "A 70 ns high density 64KCMOS dynamic RAM"

## Description

L'invention concerne une unité de mémoire contenant une pluralité de cellules dé mémoire vive dite RAM, statique ou dynamique, comportant entre autres une entrée de sélection d'unité et une entrée à plusieurs bits en parallèle pour les données d'adresse présentées à l'unité, munie de circuits de sélection des cellules et de circuits-tampons d'entrée d'adresse qui, pour chaque bit d'entrée, possèdent une paire de connexions de sortie sur laquelle, en fonctionnement de lecture ou d'écriture, sont présents deux signaux complémentaires l'un de l'autre, lesdits circuits-tampons étant munis de moyens pour que les deux susdits signaux présentent tous le même état significatif, dans une paire de connexions et aussi d'une paire à l'autre, lorsqu'un signal de désélection est présent à l'entrée de sélection d'unité.

Il est connu par le document US-4 412 309 de munir une mémoire effaçable électriquement et programmable dite EEPROM de circuits tels que les deux susdits signaux présentent tous les deux le même état significatif, lorsqu'un signal de désélection est présent à l'entrée de sélection d'unité. Quand les deux susdits signaux présentent tous les deux le même état significatif, plusieurs lignes ou colonnes peuvent être programmées simultanément. Il en résulte que le temps de programmation est diminué. Une telle diminution est nécessaire dans le cas d'une mémoire EEPROM parceque sans cela le temps nécessaire pour programmer la mémoire est comparativement long (plusieurs secondes) par rapport au temps nécessaire pour lire le contenu de la mémoire. Dans cette unité de mémoire, le signal provenant de l'entrée de sélection (chip enable ou chip select en langue anglaise) est fourni au circuit-tampon mais aussi à la plupart des circuits de décodage de l'unité, pratiquement comme s'il s'agissait d'un bit d'adresse supplémentaire.
Dans le cas de mémoire plus rapides, où on peut écrire (que l'on peut "programmer") à vitesse élevée, une réduction du temps de programmation ne semble pas être nécessaire. D'autres buts, comme l'amélioration de la testabilité, la réduction de la puissance dissipée, etc... sont poursuivis. Par la même occasion une amélioration de la vitesse peut être obtenue. Ainsi l'invention a entre autres pour objet de diminuer la puissance consommée et d'améliorer la testabilité. Elle est basée sur l'idée que si un décodeur d'adresses sélectionne une ligne lorsqu'il reçoit sur ses entrées un jeu de paires de signaux complémentaires, il est aussi possible de tirer partie d'un autre cas de figure : celui qui correspond à des signaux égaux sur les paires.

Une mémoire selon l'invention est ainsi remarquable en ce que les circuits de sélection sont munis de moyens pour ne sélectionner aucune cellule lorsque les deux susdits signaux présentent le même état significatif.

Comme il existe deux cas différents dans lesquels les deux signaux sont égaux, il est avantageux de prévoir une entrée supplémentaire dite d'écriture générale, qui permet d'écrire simultanément dans une pluralité de cellules de mémoire, de munir le circuit-tampon de moyens pour que les deux susdits signaux présentent tous le même état significatif, dans une paire et aussi d'une paire à l'autre, lorsque l'entrée d'écriture générale est activée, cet état étant inverse de celui obtenu lorsqu'un signal de désélection est présent, et de munir les circuits de sélection de moyens pour sélectionner toutes les cellules lorsque les deux susdits signaux présentent le même état significatif inverse de celui obtenu lorsqu'un signal de désélection est présent.

L'unité de mémoire selon l'invention présente de multiples avantages qui seront expliqués plus facilement, en même temps que la mise en oeuvre de l'invention, à l'aide de la description qui va suivre, en regard des dessins annexés décrivant des exemples non limitatifs.

La figure 1 est un schéma synoptique de l'organisation générale d'une unité de mémoire.

La figure 2 est un exemple de circuit d'adressage opérant à partir des sorties du circuit-tampon d'entrée d'adresse.

La figure 3 est un exemple de circuit d'adressage opérant à partir de circuits du genre de celui de la figure 2.

La figure 4 est un schéma de réalisation d'un circuit-tampon d'entrée d'adresse selon l'invention.

La figure 5 est un schéma détaillé de l'un des éléments 24 ou 26 de la figure 4.

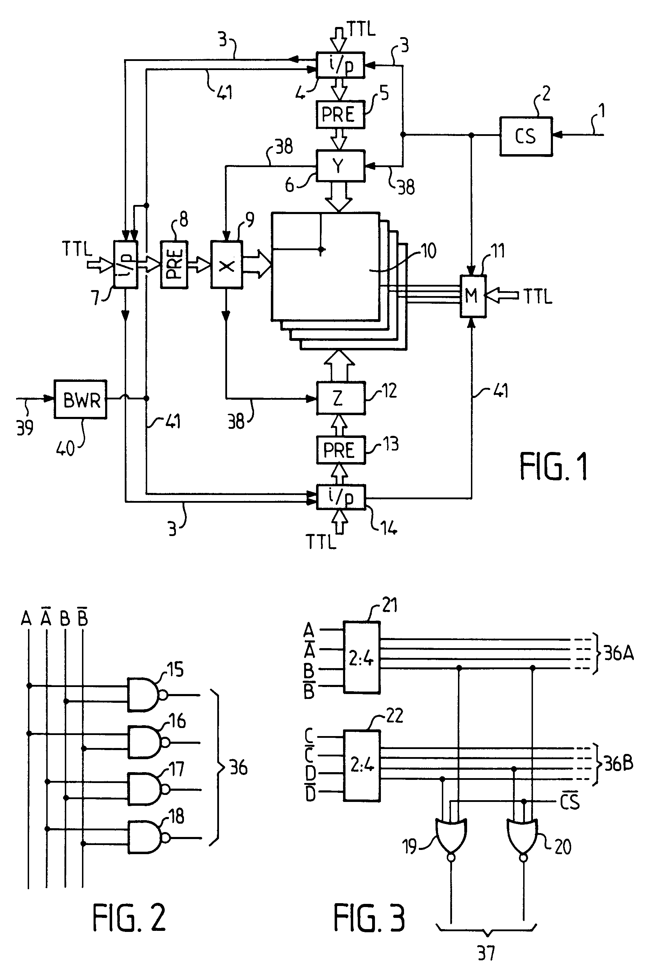

L'unité de mémoire vive à accès direct de la figure 1 est, dans le présent exemple, réalisé en technologie MOS complémentaire ou C-MOS et comporte quatre sous-unités 10 contenant chacune une pluralité de cellules de mémoire. Le circuit 11 de sélection de sous-unités choisit une parmi les quatre sous-unités en fonction de la valeur de deux des bits d'adresse TTL à l'entrée. Chaque sous-unité est divisée en 16 blocs qui sont adressés selon une variable indiquée par Z, décodée à partir de quatre des bits TTL d'adresse à l'entrée. Les cellules de mémoire de chacun des 16 blocs sont adressées par coordonnée X,Y.

Chacun des circuits de sélection Z,X,Y, est organisé de la même façon : il comprend un circuit-tampon i/p d'entrée d'adresse, respectivement 14, 7, 4, un circuit de prédécodage, respectivement 13, 8, 5, et un circuit de sélection de lignes, respectivement 12, 9, 6.

Un signal de sélection d'unité CS est amené sur l'entrée 1 au circuit tampon 2 puis par les connexions 3 et 38 aux différents circuits de l'unité. Le schéma général qui vient d'être décrit est donné à titre purement indicatif, entre autres pour supporter la description des avantages de l'invention.

Chacun des circuits-tampons d'entrée d'adresse 4, 7, 14 qui sera décrit plus loin comporte une entrée parallèle pour des bits d'adresse présentés à l'unité, et pour chaque bit, une paire de connexions sur laquelle sont présents, en fonctionnement normal de lecture ou d'écriture, deux signaux complémentaires. Ces signaux complémentaires A,A̅ ou bien B,B̅, etc. sont fournis à des éléments de circuit de prédécodage tel que celui représenté par la figure 2 (éléments qui sont contenus dans les blocs 13, 8, 5 de la figure 1). Il s'agit ici d'un élément de sélection de type démultiplexeur qui choisit une ligne parmi quatre en fonction de la valeur de deux bits d'entrée indiqués par A et B, ainsi que les signaux complémen taires respectifs A̅ et B̅. Il comporte quatre portes NON-ET dont les paires d'entrées sont reliées respectivement à A,B, à A,B̅, à A̅,B et à A̅,B̅ et dont les sorties sont les lignes à sélectionner 36. Il est aisé de vérifier que pour chacune des quatre configurations possibles pour le couple A,B, une seule ligne est sélectionnée (avec un niveau logique bas).

Pour sélectionner seize lignes, le circuit de la figure 3 utilise un élément 21, du type représenté à la figure 2 avec deux entrées A et B et un deuxième élément identique 22 avec deux entrées C, D. Il y a donc deux groupes de quatre lignes 36A, 36B, avec une ligne sélectionnée (état bas) par groupe. A ces lignes sont connectées seize portes NON-OU dont deux seulement 19, 20 sont représentées pour alléger la figure. Deux entrées de chacune de ces seize portes sont reliées chacune à une ligne d'un des deux groupes 36 ; bien entendu les portes 19, 20, etc. sont reliées à une paire de lignes différente à chaque fois. Une seule des sorties des portes NON-OU est donc à l'état logique haut en fonctionnement normal de lecture ou d'écriture. Ce circuit illustre par exemple le contenu de l'élément 12 de la figure 1, qui sélectionne un parmi seize blocs.

Les circuits X et Y, 9 et 6, sont basés sur le même principe avec des sélecteurs plus complexes pour choisir une ligne X et une ligne Y dans chaque bloc. On peut imaginer facilement de telles extensions des sélecteurs : par exemple, en réalisant le circuit de la figure 2 avec des portes NON-ET à trois entrées et avec trois entrées A,B,C on réaliserait la sélection d'une ligne parmi huit en fonction de trois bits.

On peut aussi imaginer en variante, de constituer les éléments de la figure 2 avec des portes NON-OU, ce qui mettrait à l'état haut la seule ligne sélectionnée, et le circuit de la figure 3 serait alors réalisé avec des portes NON-ET ou ET.

Le circuit de la figure 3 correspond à l'art antérieur : le signal de sélection d'unité C̅S̅ était amené à chacune des seize portes 19, 20, etc. de la figure 3 et aussi à toutes les portes similaires non représentées des autres circuits de sélection, de manière à désélectionner toutes les lignes (pour éviter de consommer du courant), même si une adresse continue d'être présentée à l'entrée de l'unité (si C̅S̅ est à 1, toutes les sorties des portes 19, 20, ... sont à 0).

Selon l'invention, les circuits-tampons 4, 7, 14 sont munis de moyens pour que les deux signaux A, A̅ présentent le même état haut ou bas, et que les signaux B, B̅ présentent aussi le même état, et de même pour toutes les paires de signaux, lorsqu'un signal de désélection est présent à l'entrée de l'unité c'est-à-dire ici lorsque CS est à zéro.

Dans l'exemple de la figure 2 où le circuit de prédécodage est réalisé avec des portes NON-ET, l'état en question des paires A, A̅ ou B, B̅, etc. doit être l'état bas. Alors aucune ligne n'est sélectionnée : toutes les portes 15 à 18 ont leurs sorties à l'état haut. Dans le cas de la variante où le circuit de prédécodage est réalisé avec des portes NON-OU, l'état des paires A, A̅ ou B, B̅, etc. doit être l'état haut. Alors toutes les portes NON-OU ont leurs sorties à l'état bas et aucune ligne n'est sélectionnée. Bien entendu il s'ensuit qu'aucune des lignes 37 de la figure 3 non plus n'est sélectionnée, et il est alors inutile d'amener la connexion C̅S̅ à toutes les portes NON-OU de la figure 3. Les connexions 38 de la figure 1 disparaissent.

Ceci présente un double avantage : cela simplifie la topographie en éliminant une connexion qui dessert de nombreux points, et en outre chacune des portes 19, 20, etc. a une entrée de moins et est réalisable sur une plus petite surface et de ce fait est plus rapide (moins de capacités parasites).

En outre, dans l'art antérieur, lorsqu'on change d'adresse en même temps qu'on sélectionne l'unité, le signal CS arrive immédiatement par la connexion 38 (figure 1) sur les éléments 6, 9, 12. Les sélecteurs d'adresses mettent en oeuvre des éléments de circuit intermédiaires et de ce fait la sélection d'adresses n'est réalisée qu'avec un petit retard par rapport au signal CS. Pendant ce temps de retard, une fausse adresse a pu être utilisée, et une donnée fausse fournie en sortie. Pour éviter cela on introduisait un retard en série dans la connexion 38. Avec l'invention ce retard n'existe plus et le circuit est plus rapide.

Un autre avantage est que, s'il y a changement d'adresse pendant la désélection, rien ne se produit dans les circuits 5, 6, 8, 9, 13, 12 jusqu'à la sélection subséquente, alors que dans l'art antérieur on avait alors une consommation de courant (en C-MOS se sont les transitions qui consomment de l'énergie). En outre, lors de la resélection subséquente, c'est une seule des deux lignes A ou A̅ qui doit changer d'état pour modifier un bit d'adresse, au lieu de deux dans l'art antérieur. Ce fait procure un avantage : du fait que le nombre des portes qui doivent basculer lors d'un changement d'adresse est diminué de moitié, l'appel de courant est moins fort lors de la transition, les sautes de tension de masse ou d'alimentation qui en résultent sont plus faibles et le fonctionnement est donc plus sûr.

La fiabilité est améliorée aussi du fait que le nombre de transistors est réduit dans les portes 19, 20, etc.

Il y a aussi moins de situations de "compétition" entre des signaux dont l'un doit impérativement arriver avant l'autre, et de ce fait il y a moins de situations sensibles risquant d'entraîner des anomalies en cas d'écart sur les caractéristiques physiques résultant de dispersions dans le procédé de fabrication.

En dehors de l'état A=A̅=0 dont l'utilisation a été décrite ci-dessus, il y a bien sûr les états A=1/A̅=0 et A=0/A̅=1 qui sont les états normaux rencontrés dans le fonctionnement en lecture ou en écriture et qui représentent chacun l'état d'un bit d'adresse ; il y a aussi l'état A=A̅=1 qui est "anormal". Il est avantageux d'utiliser cet état pour définir une situation utile. A cet effet l'unité comporte une entrée dite d'écriture générale, sous la commande de laquelle on peut écrire simultanément dans une pluralité de cellules de mémoire. Cette entrée est en tout point semblable à l'entrée CS avec son circuit-tampon d'entrée 40 et un accès 41 à tous les circuits-tampons d'adresse 4, 7, 14.

Chacun des circuits-tampons est muni de moyens pour que la paire de signaux A, A̅ et la paire B, B̅ et toutes les autres paires soient dans le même état logique, inverse de celui qui correspond à la désélection, lorsque l'entrée d'écriture générale est activée. Dans le cas présent cet état est A=A̅=1. Alors toutes les lignes correspondant à toutes les cellules sont activées. Ceci permet d'écrire dans toutes les cellules à la fois, et de réaliser par exemple une remise à zéro simultanée de toute l'unité de mémoire.

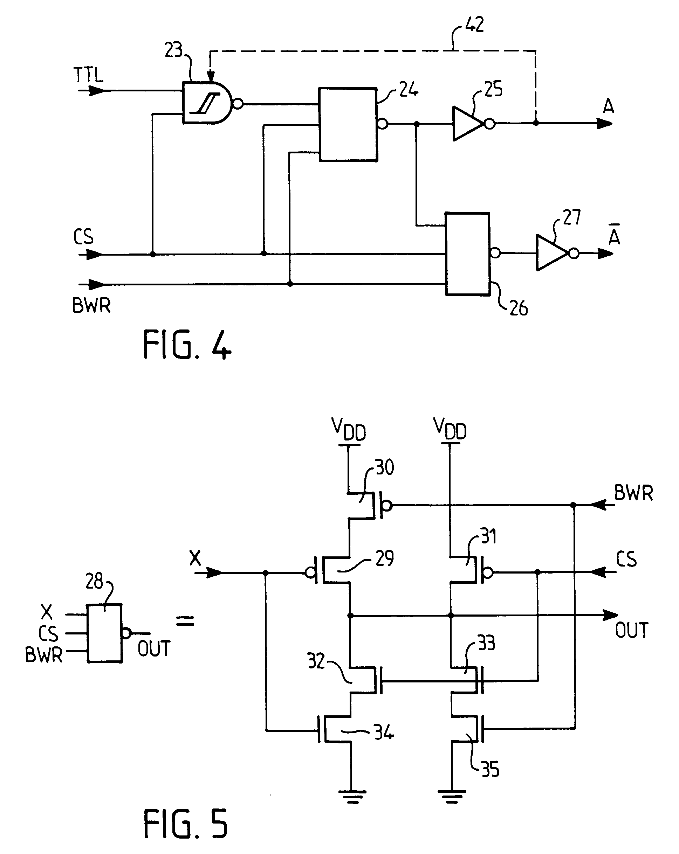

La figure 4 représente un mode de réalisation préféré d'un élément de circuit-tampon d'entrée d'adresse, élément correspondant à un bit. Bien entendu les circuits 4, 7, 14 de la figure 1 comportent autant de fois le circuit de la figure 4 qu'il y a de bits en parallèle à leur entrée.

Un bit d'adresse, par exemple avec un niveau dit TTL (niveau bas : 0,8 volt, niveau haut : 2,4 volts), est fourni sur une entrée TTL de la porte NON-ET 23, le signal CS étant fourni à son autre entrée. La sortie de la porte 23 est reliée à une entrée de l'élément 24. Les deux éléments 24 et 26 sont identiques. Leurs trois entrées ne sont pas interchangeables. Le signal de sélection CS est amené à l'entrée centrale, sur le dessin des éléments 24 et 26, et le signal d'écriture générale BWR est amené à leur entrée inférieure sur le dessin.La sortie de l'élément 24 est reliée à l'entrée supérieure sur le dessin de l'élément 26. Enfin les sorties des deux éléments 24 et 26 fournissent, chacune via un inverseur respectivement 25, 27, les signaux respectivement A et A̅.

Une ligne en pointillés 42 symbolise une contre-réaction qui provoque un effet d'hystérésis, et ne fait pas partie de l'invention.

L'un des éléments identiques 24 ou 26 est représenté par la figure 5. Les références X, CS, BWR, indiquent respectivement les entrées appelées ci-dessus supérieure, centrale, et inférieure.

On est en présence d'une porte NON-ET avec X et CS comme entrées, constituée de façon connue par les deux transistors à canal P, 29, 31 en parallèle entre l'alimentation VDD et la sortie OUT, et deux transistors à canal N, 32, 34 en série entre la masse et la sortie, mais à laquelle sont ajoutés deux transistors commandés par le signal BWR :
- un transistor 30 à canal P en série avec le transistor 29,
- un transistor 35 à canal N, connecté en série avec un transistor 33 à canal N commandé par CS entre la sortie OUT et la masse.

On constate que :
- Si CS=0 on a OUT=1 quels que soient X et BWR.
- Si CS=1 et BWR=X=0, on a OUT=1 aussi.
- Si CS=1 et X=1, ou bien si CS=1 et BWR=1, on a OUT=0 quel que soit l'état de la troisième entrée.

Appliquant ces résultats au circuit de la figure 4 on constate que :
- Si CS=0, on a A=A̅=0 quels que soient BWR et TTL.
- Si CS=1 et BWR=1, on a A=A̅=1 quel que soit TTL.
- Si CS=1 et BWR=0, A et A̅ sont complémentaires et A=TTL.

Le circuit de la figure 4 constitue donc un moyen de fournir les états selon l'invention pour les signaux A et A̅.

Si on désire utiliser l'invention seulement en ce qui concerne CS et pas BWR, il suffit de remplacer chaque élément 24 ou 26 par une simple porte NON-ET à deux entrées, ces deux entrées étant connectées comme les entrées supérieure et centrale des éléments 24, 26.

## Revendications

1. Unité de mémoire contenant une pluralité de cellules de mémoire vive dite RAM, statique ou dynamique, comportant entre autres une entrée de sélection d'unité (1) et une entrée à plusieurs bits en parallèle (TTL, scindés en plusieurs parties) pour les données d'adresse présentées à l'unité, munie de circuits (6,9,12) de sélection des cellules et de circuits-tampons d'entrée d'adresse (4,7,14) qui, pour chaque bit d'entrée, possèdent une paire de connexions de sortie sur laquelle, en fonctionnement de lecture ou d'écriture, sont présents deux signaux complémentaires l'un de l'autre (A,A̅,B,B̅,C,C̅, etc), lesdits circuits-tampons étant munis de moyens pour que les deux susdits signaux présentent tous le même état significatif, dans une paire de connexions et aussi d'une paire à l'autre, lorsqu'un signal de désélection est présent à l'entrée de sélection d'unité, caractérisée en ce que les circuits de sélection sont munis de moyens pour ne sélectionner aucune cellule lorsque les deux susdits signaux présentent le même état significatif.

2. Unité selon la revendication 1, caractérisé en ce qu'elle comporte en outre une entrée (39) dite d'écriture générale, qui permet d'écrire simultanément dans une pluralité de cellules de mémoire, en ce que lesdits circuits-tampons (4,7,14) sont munis de moyens pour que les deux susdits signaux présentent tous le même état significatif, dans une paire et aussi d'une paire à l'autre, lorsque l'entrée d'écriture générale est activée, cet état étant inverse de celui obtenu lorsqu'un signal de désélection est présent, et en ce que les circuits de sélection (6,9,12) sont munis de moyens pour sélectionner toutes les cellules lorsque les deux susdits signaux présentent le même état significatif inverse de celui obtenu lorsqu'un signal de désélection est présent.

## Claims

1. A memory unit with a plurality of so-called static or dynamic RAM memory cells, comprising *inter alia* a unit selection input (1) and a parallel multi-bit input (TTL, sub-divided into several parts) for the address data presented to the unit, provided with cell selection circuits (6, 9, 12) and address input buffer circuits (4, 7, 14) which have, for each input bit, a pair of output connections on which, in the read or the write mode, two signals (A, A̅, B, B̅, C, C̅, etc.) are present which are complementary to one another, said buffer circuits being provided with means to ensure that the two said signals all exhibit the same significant state, within a pair of connections and also from one pair to the other, when a deselection signal is present at the unit selection input, characterized in that the selection circuits are provided with means ensuring that no cell whatsoever is elected when the two said signals exhibit the same significant state.

2. A unit as claimed in Claim 1, characterized in that it also comprises an input (39) which is referred to as a general write input and which enables simultaneous writing in a plurality of memory cells, that said buffer circuits (4, 7, 14) are provided with means ensuring that the two said signals all exhibit the same significant state, within a pair and also from one pair to the other, when the general write input is activated, this state being the inverse of that obtained when a deselection signal is present, and that the selection circuits (6, 9, 12) are provided with means for selecting all cells when the two said signals exhibit the same significant state which is the inverse of that obtained when a deselection signal is present.

## Patentansprüche

1. Speichereinheit, die eine Vielzahl von Speicherzellen eines sog. statischen oder dynamischen RAM-Speichers enthält, die unter anderem mit einem Eingang zur Einheitenauswahl (1) und einem Paralleleingang für mehrere Bits (TTL, aufgeteilt in mehrere Abschnitte) für die an die Einheit angelegten Adreßdaten ausgestattet ist, und die mit Speicherzellen-Auswahlschaltungen (6, 9, 12) sowie mit Adreß-Eingangspufferschaltungen (4, 7, 14) versehen ist, die für jedes Eingangsbit ein Paar Ausgangsanschlüsse aufweisen, an denen im Schreib- oder Lesebetrieb zwei zueinander komplementäre Signale (A, A̅,̅ B, B̅, C, C̅ usw...) anliegen und wobei die genannten Pufferschaltungen Mittel enthalten, damit diese beiden Signale innerhalb eines Anschlußpaares, und auch von einem Paar zum nächsten, denselben signifikanten Zustand aufweisen, wenn am Einheiten-Auswahleingang ein Abwahlsignal anliegt, dadurch gekennzeichnet, daß die Auswahlschaltungen Mittel enthalten, um keine Zelle auszuwählen, wenn die Signalpaare denselben signifikanten Zustand aufweisen.

2. Speichereinheit nach Anspruch 1, dadurch gekennzeichnet, daß sie außerdem einen sog. allgemeinen Schreibeingang (39) enthält, der das gleichzeitige Beschreiben einer Vielzahl von Speicherzellen ermöglicht, daß die genannten Pufferschaltungen (4, 7, 14) Mittel enthalten, damit die beiden Signale innerhalb eines Anschlußpaares, und auch von einem Paar zum nächsten, denselben signifikanten Zustand aufweisen, wenn der allgemeine Schreibeingang aktiviert ist, wobei dieser Zustand demjenigen Zustand, der bei Vorliegen eines Abwahlsignals auftritt, entgegengesetzt ist, und daß die Auswahlschaltungen (6, 9, 12) Mittel enthalten, um alle Zellen zu wählen, wenn die beiden genannten Signale denselben signifikanten Zustand aufweisen, der demjenigen Zustand, der bei Vorliegen eines Abwahlsignals auftritt, entgegengesetzt ist.
